# FASCICULE DE BREVET EUROPEEN

(11) **EP 3 347 987 B1**
(45) Date de publication et mention de la délivrance du brevet: **10.05.2023**
(21) Numéro de dépôt: 16775304.5
(22) Date de dépôt: 12.09.2016
(51) Int. Cl.: H03K 17/16, H02M 1/08

(54) **DISPOSITIF ÉLECTRONIQUE DE CONTRÔLE D'UN COMMUTATEUR, NOTAMMENT POUR VÉHICULE AUTOMOBILE**
ELEKTRONISCHE STEUERUNGSVORRICHTUNG FÜR EINEN SCHALTER, INSBESONDERE FÜR EIN KRAFTFAHRZEUG
ELECTRONIC CONTROL DEVICE FOR A SWITCH, IN PARTICULAR FOR AN AUTOMOTIVE VEHICLE

(30) Priorité: 11.09.2015 FR 1558491
(43) Date de publication de la demande: 18.07.2018
(73) Titulaire: Valeo eAutomotive France SAS, 95800 Cergy (FR)
(72) Inventeur: GRENIER, Mathieu, 78800 Houilles (FR); BLONDEL, Gael, 91860 Epinay-sous-Senart (FR)
(74) Mandataire: Valeo Powertrain Systems
(86) Numéro de dépôt international: PCT/FR2016/052293
(87) Numéro de publication internationale: WO 2017/042522

(56) Documents cités:
- EP-A1- 2 615 737
- WO-A1-2014/009668
- WO-A1-2015/070344
- US-A- 5 926 012
- US-B1- 6 304 472

## Description

La présente invention concerne un dispositif électronique, notamment pour véhicule automobile.

On connait des commutateurs formés par des transistors IGBT. Par exemple, le document US 6,304,472 B1 divulgue un dispositif selon le préambule de la revendication 1.

Lors de la commutation de ce type de commutateurs, la variation du courant de puissance peut être très élevée, ce qui peut créer une tension électrique excessive aux bornes du commutateur qui peut endommager ce dernier.

La présente invention vise à remédier à cet inconvénient.

L'invention a ainsi pour objet un dispositif électronique selon la revendication 1.

Grâce à l'invention, il est possible d'obtenir une image du courant de puissance qui traverse le commutateur lors de la phase de commutation, ce qui permet de contrôler la variation du courant de puissance, et ceci par la mesure de la différence de potentiels entre deux points de mesure entre lesquels l'inductance est présente.

L'invention permet notamment d'avoir un dispositif plus fiable.

L'invention permet d'avoir une mesure optimale de la variation du courant en ayant une valeur d'inductance suffisante.

D'autres modes de réalisation avantageux sont définis dans les revendications dépendantes.

L'invention sera mieux comprise et d'autres détails, caractéristiques et avantages de l'invention apparaîtront à la lecture de la description suivante faite à titre d'exemple non limitatif en référence au dessin annexé dans lequel :
- les figures 1 à 3 et représentent, schématiquement et partiellement, un dispositif électronique selon plusieurs exemples de réalisation de l'invention non couverts par les revendications ;
- la figure 4 représente, schématiquement et partiellement, un dispositif électronique selon un mode de réalisation de l'invention ;
- les figures 6 et 7 illustrent un exemple de mode réalisation de l'invention non couvert pas les revendications.

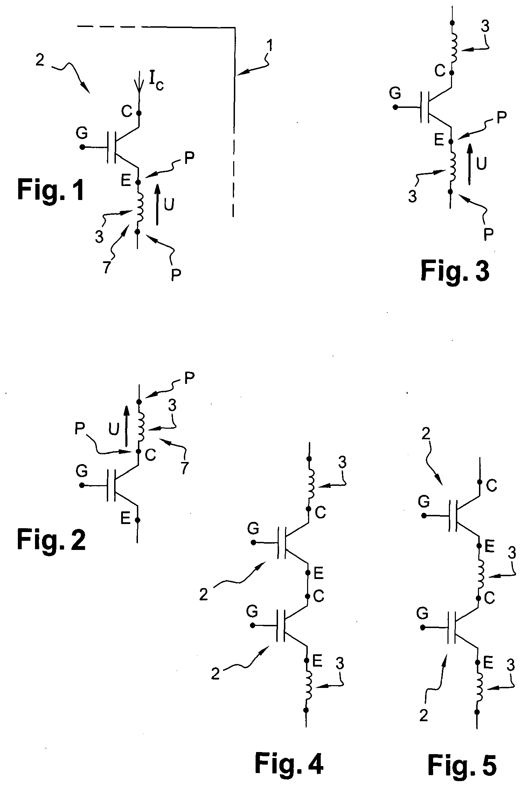

On a représenté sur la figure 1 un dispositif électronique 1, pour véhicule automobile, ce dispositif comportant :
- un commutateur 2 agencé pour passer d'un état fermé à un état ouvert,
   - le commutateur étant traversé par un courant électrique de puissance Ic dans l'état fermé,
   - le commutateur bloquant le passage du courant électrique de puissance Ic dans l'état ouvert,
   - le commutateur présentant une fréquence Fdl/dt de la variation du courant de puissance lorsque, dans une phase de commutation, le commutateur 2 commute de l'état fermé à l'état ouvert,
- deux points de mesure P de potentiel électrique agencés de sorte que, dans la phase de commutation de l'état fermé à l'état ouvert, une inductance 3 existante entre ces deux points de mesure s'accompagne d'une différence de potentiels U, ou tension U, entre les deux points P,
le dispositif 1 étant agencé pour permettre le contrôle, dans la phase de commutation, de la variation du courant de puissance passant le commutateur à l'aide de cette différence de potentiels.

Dans l'exemple décrit, le commutateur 2 est un transistor IGBT, lequel comprend un collecteur C, un émetteur E et une grille G. Ce transistor 2 est contrôlé par une tension de grille entre la grille G et l'émetteur E.

La fréquence Fdl/dt de la variation du courant de puissance Ic est comprise, pour le fondamental, entre 10MHz et 50MHz.

L'inductance entre les deux points de mesure P de potentiel est supérieure à 2nHenry.

A des fréquences inférieures à la fréquence Fdl/dt de la variation du courant de puissance, notamment des fréquences 100 fois plus petites que la fréquence Fdl/dt de la variation du courant de puissance, les potentiels aux deux points de mesure P sont sensiblement égaux.

Dans la phase de commutation, la différence de potentiels U entre les deux points de mesure P est utilisée pour déterminer la variation de courant de puissance traversant le commutateur. La valeur de la tension U est proportionnelle à la variation du courant avec comme coefficient de proportionnalité la valeur de l'inductance entre les deux points de mesure. Dans la phase de commutation, la différence de potentiels U entre les deux points de mesure est maintenue constante à l'aide d'un contrôle du courant de puissance traversant le commutateur.

Dans l'exemple de la figure 1, les deux points de mesure P sont disposés en aval du commutateur 2.

Dans ce cas, l'un des deux points de mesure P est avantageusement placé à l'émetteur E du commutateur 2.

En variante, comme illustré sur la figure 2, les deux points de mesure P sont disposés en amont du commutateur 2.

Dans ce cas, l'un des deux points de mesure P est avantageusement placé au collecteur C du commutateur 2.

Comme illustré sur la figure 3, il est possible de prévoir la présence d'inductances 3 à la fois en amont et en aval du commutateur 2, et dans ce cas, d'utiliser une seule des deux inductances 3 pour contrôler la variation du courant de puissance Ic lors des phases de commutation. Ceci permet une liberté de choix dans les solutions électroniques du dispositif. En effet, d'un point de vue électronique, la mesure de différence de potentiels en entrée ou en sortie du commutateur 2 est indifférente.

On a représenté sur les figures 4 et 5 un dispositif 1 comportant deux commutateurs 2 en série.

Dans le mode de réalisation de la figure 4, l'une des inductances 3 est en amont des deux IGBT, et l'autre inductance 3 est en aval des deux IBGT.

En revanche, dans l'exemple de la figure 5, l'une des inductances 3 est disposée entre les deux IBGT, et l'autre des inductances 3 est en aval des deux IGBT.

Bien entendu, d'autres combinaisons de placement des inductances sont possibles.

Dans un exemple non représenté, le dispositif peut comporter six commutateurs, par groupe de deux en série, les trois groupes étant en parallèle.

Dans les exemples décrits, les deux points de mesure P sont reliés entre eux par un chemin électrique formé par un conducteur électrique 7, comportant une piste conductrice ou un barreau conducteur notamment busbar, ou une patte de liaison électrique.

Avantageusement le chemin électrique entre les deux points est dépourvu de composant électronique spécifique à inductance, notamment dépourvu de bobine d'inductance.

Le dispositif selon l'invention peut former un module de puissance électronique, ou *Power Module* en anglais, ou équiper un onduleur.

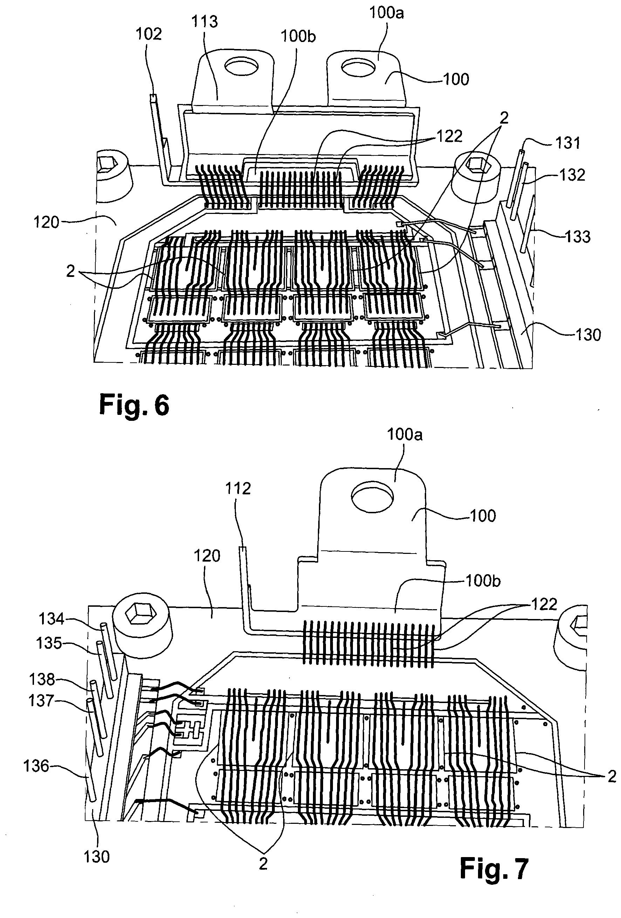

Les figures 6 et 7 illustrent un exemple de mode réalisation de l'invention non couvert par les revendications dans lequel un des points de mesure P est une broche 102, 112 intégrale avec une borne conductrice électriquement 100, 110. La borne conductrice électriquement 100, 110 connecte le commutateur 2 avec un élément extérieur au dispositif électronique 1 en recevant le courant électrique de puissance Ic.

La borne conductrice électriquement peut être une borne 100 configurée pour être connectée à une borne d'une source d'alimentation du dispositif électronique 1, par exemple comme illustré en figure 6. Notamment, la borne 100 peut être connectée à une borne négative de la source d'alimentation du dispositif électronique 1.

La borne conductrice électriquement peut être une borne 110 configurée pour être connectée à un élément extérieur commandé par le courant électrique de puissance Ic, par exemple comme illustré en figure 7. Notamment, la borne 110 peut être configurée pour être connectée à une phase d'une machine électrique.

Dans l'art antérieur, les points de mesure sont formés par des broches séparées des bornes électriques 100, 110 et reliées au collecteur ou à l'émetteur des commutateurs 2. Le contrôle de la variation du courant de puissance Ic dans le dispositif 1 implique alors une étape spécifique de connexion électrique. Dans ce mode de réalisation non couvert par les revendications, en intégrant la broche 102, 112 dans une borne électrique 100, 110 du dispositif 1, on évite l'étape supplémentaire de connexion électrique, puisque la borne 100, 110 est de toute façon reliée au commutateur 2 pour que celui-ci réalise sa fonction électronique.

Notamment, la borne 100, 110 peut être une pièce d'un seul tenant comprenant une première portion 100a, 110a destinée à recevoir une connexion d'un élément extérieur au dispositif 1 et une deuxième portion 100b, 110b destinée à recevoir une connexion du commutateur 2.

Dans un exemple particulier, le dispositif électronique 1 comprend la première borne 100 configurée pour être connectée à une borne d'une source d'alimentation du dispositif électronique 1 et la deuxième borne 110 configurée pour être connectée à un élément extérieur commandé par le courant électrique de puissance Ic. Dans l'exemple illustré en figure 6, 7, plusieurs commutateurs 2 sont en parallèle. La figure 6 représente les commutateurs du côté bas qui correspondent notamment au commutateur situé dans la partie basse du bras illustré en figure 5. La figure 7 représente les commutateurs du côté haut qui correspondent notamment au commutateur situé dans la partie haute du bras illustré en figure 5.

Notamment, les première et deuxième bornes 100, 110 peuvent être positionnées en périphérie d'un substrat 120 sur lequel les commutateurs 2 sont montés. En particulier, les première et deuxième bornes 100, 110 peuvent être positionnées sur des bords opposés du substrat 120. Le dispositif 1 peut aussi comprendre une borne 130, dite borne de contrôle, destinée à réaliser une connexion électrique entre le dispositif 1 et une unité de commande des interrupteurs qui est extérieure au dispositif 1, notamment une carte de contrôle.

La première 100 ou deuxième 110 borne peut être connectée avec une borne du commutateur 2 par une ou plusieurs pattes de liaison électrique 122. En particulier, la deuxième portion 100b de la première borne 100 peut être connectée par des pattes de liaison 122 à une extrémité d'une inductance 3 en aval du commutateur 2 côté bas. Une première broche 131 de la borne de contrôle 130 peut être connectée à l'émetteur E du commutateur 2 côté bas. Une deuxième broche 132 de la borne de contrôle 130 peut être connectée à la grille G du commutateur 2 côté bas. Une troisième broche 133 peut être connectée au collecteur C du commutateur côté bas.

La deuxième portion 110b de la deuxième borne 110 peut être connectée par des pattes de liaison 122 à une extrémité d'une inductance 3 en aval du commutateur 2 côté haut. En particulier, une quatrième broche 134 de la borne de contrôle 130 peut être connectée à l'émetteur E du commutateur 2 côté haut. Une cinquième broche 135 de la borne de contrôle 130 peut être connectée à la grille G du commutateur 2 côté haut. Une sixième broche 136 peut être connectée au collecteur C du commutateur côté haut.

La borne de contrôle 130 peut aussi comprendre des broches 137, 138 connectées à un capteur de température monté sur le substrat 120.

Une troisième borne 113 peut être superposée à la première borne 100 pour être connectée à la source d'alimentation électrique. La troisième borne 113 est notamment configurée pour être connectée à une borne de la source d'alimentation qui a une polarité opposée à celle connectée à la première borne 100.

## Revendications

1. Dispositif électronique (1) de contrôle de deux commutateurs, notamment pour véhicule automobile, ce dispositif comportant les deux commutateurs (2) en série :
- lesdits deux commutateurs (2) étant respectivement agencés pour passer d'un état fermé à un état ouvert :
• quand un des deux commutateurs (2) est dans l'état fermé, ledit commutateur (2) est traversé par un courant électrique de puissance (Ic),
• quand un des deux commutateurs (2) est dans l'état ouvert, ledit commutateur (2) bloque le passage du courant électrique de puissance ;
• quand un des deux commutateurs (2) est dans une phase de commutation, ledit commutateur (2) commute de l'état fermé à l'état ouvert, ou de l'état ouvert à l'état fermé, et ledit commutateur (2) est traversé par un courant de puissance présentant une fréquence (Fdl/dt) de la variation du courant de puissance ;
- pour chacun des commutateurs, deux points de mesure (P) de potentiel électrique sont agencés de sorte que, dans la phase de commutation de l'état fermé à l'état ouvert il existe une inductance entre ces deux points de mesure correspondant à une différence de potentiels entre les deux points, le dispositif étant par ailleurs agencé pour permettre le contrôle, dans la phase de commutation, de la variation du courant de puissance passant le commutateur à l'aide de cette différence de potentiels,
le dispositif étant **caractérisé en ce que** l'inductance de l'un des commutateurs est en amont des deux commutateurs et l'inductance de l'autre commutateur est en aval des deux commutateurs.

2. Dispositif selon la revendication précédente, la fréquence (Fdl/dt) de la variation du courant de puissance étant comprise, pour le fondamental, entre 1MHz et 100MHz, notamment comprise entre 10MHz et 50MHz.

3. Dispositif selon la revendication 1 ou 2, l'inductance entre les deux points de mesure de potentiel étant supérieure à 0.5 nHenry, notamment supérieure à 1nHenry, par exemple 2nHenry.

4. Dispositif selon l'une des revendications précédentes, à des fréquences inférieures à la fréquence (Fdl/dt) de la variation du courant de puissance, notamment des fréquences 100 fois plus petites que la fréquence (Fdl/dt) de la variation du courant de puissance, les potentiels aux deux points de mesure sont égaux.

5. Dispositif selon l'une des revendications précédentes, dans la phase de commutation, la différence de potentiels entre les deux points de mesure est utilisée pour déterminer la variation de courant de puissance traversant le commutateur.

6. Dispositif selon l'une des revendications précédentes, dans la phase de commutation, la différence de potentiels entre les deux points de mesure est maintenue constante à l'aide d'un contrôle du courant de puissance traversant le commutateur.

7. Dispositif selon l'une des revendications précédentes, le commutateur est un transistor, notamment un transistor IGBT.

8. Dispositif selon l'une des revendications précédentes, les deux points de mesure sont reliés entre eux par un chemin électrique formé par un conducteur électrique (7), comportant de préférence une piste conductrice ou un barreau conducteur notamment busbar, ou une patte de liaison électrique.

9. Dispositif selon l'une des revendications précédentes, formant un onduleur.

10. Dispositif selon l'une des revendications précédentes, comprenant une borne conductrice électriquement (100, 110) recevant ledit courant électrique de puissance (Ic) et configurée pour connecter ledit commutateur (2) avec un élément extérieur au dispositif, et
dans lequel au moins un des deux points de mesure est une broche (102, 112) intégrale avec ladite borne conductrice électriquement (100, 110).

11. Dispositif selon la revendication précédente, dans lequel la borne conductrice électriquement est une borne (100) configurée pour être connectée à une borne d'une source d'alimentation du dispositif électronique ; ou est une borne (110) configurée pour être connectée à un élément extérieur commandé par le courant électrique de puissance (Ic).

## Patentansprüche

1. Elektronische Vorrichtung (1) zur Regelung von zwei Schaltern, insbesondere für ein Kraftfahrzeug, wobei diese Vorrichtung die zwei Schalter (2) in Reihe aufweist,
- wobei die zwei Schalter (2) eingerichtet sind, um von einem geschlossenen Zustand in einen offenen Zustand überzugehen:
• wenn einer der zwei Schalter (2) im geschlossenen Zustand ist, wird der Schalter (2) von einem elektrischen Leistungsstrom (Ic) durchflossen,
• wenn einer der zwei Schalter (2) im offenen Zustand ist, blockiert der Schalter (2) den Durchgang des elektrischen Leistungsstroms;
• wenn einer der zwei Schalter (2) in einer Schaltphase ist, schaltet der Schalter (2) vom geschlossenen Zustand in den offenen Zustand oder vom offenen Zustand in den geschlossenen Zustand, und der Schalter (2) wird von einem Leistungsstrom durchflossen, der eine Frequenz (Fdl/dt) der Änderung des Leistungsstroms aufweist;
- für jeden der Schalter sind zwei Messpunkte (P) elektrischen Potentials so eingerichtet, dass es in der Schaltphase vom geschlossenen Zustand in den offenen Zustand eine Induktivität zwischen diesen zwei Messpunkten entsprechend einer Potentialdifferenz zwischen den zwei Punkten gibt, wobei die Vorrichtung außerdem eingerichtet ist, um die Regelung, in der Schaltphase, der Änderung des durch den Schalter gehenden Leistungsstroms mit Hilfe dieser Potentialdifferenz zu ermöglichen,
wobei die Vorrichtung **dadurch gekennzeichnet ist, dass** die Induktivität eines der Schalter sich stromaufwärts vor den zwei Schaltern befindet und die Induktivität des anderen Schalters sich stromabwärts hinter den zwei Schaltern befindet.

2. Vorrichtung nach dem vorhergehenden Anspruch, wobei die Frequenz (Fdl/dt) der Änderung des Leistungsstroms grundsätzlich zwischen 1MHz und 100MHz, insbesondere zwischen 10MHz und 50MHz liegt.

3. Vorrichtung nach Anspruch 1 oder 2, wobei die Induktivität zwischen den zwei Messpunkten des Potentials höher ist als 0,5 nHenry, insbesondere höher als 1 nHenry, zum Beispiel 2 nHenry.

4. Vorrichtung nach einem der vorhergehenden Ansprüche, wobei bei niedrigeren Frequenzen als die Frequenz (Fdl/dt) der Änderung des Leistungsstroms, insbesondere Frequenzen 100 Mal kleiner als die Frequenz (Fdl/dt) der Änderung des Leistungsstroms, die Potentiale an den zwei Messpunkten gleich sind.

5. Vorrichtung nach einem der vorhergehenden Ansprüche, wobei in der Schaltphase die Potentialdifferenz zwischen den zwei Messpunkten verwendet wird, um die Änderung des den Schalter durchfließenden Leistungsstroms zu bestimmen.

6. Vorrichtung nach einem der vorhergehenden Ansprüche, wobei in der Schaltphase die Potentialdifferenz zwischen den zwei Messpunkten mit Hilfe einer Regelung des den Schalter durchfließenden Leistungsstroms Schalter konstant gehalten wird.

7. Vorrichtung nach einem der vorhergehenden Ansprüche, wobei der Schalter ein Transistor ist, insbesondere ein IGBT-Transistor.

8. Vorrichtung nach einem der vorhergehenden Ansprüche, wobei die zwei Messpunkte miteinander durch einen elektrischen Pfad verbunden sind, der von einem elektrischen Leiter (7) gebildet wird, der vorzugsweise eine Leiterbahn oder einen Leiterstab, insbesondere Busbar, oder eine elektrische Verbindungslasche aufweist.

9. Vorrichtung nach einem der vorhergehenden Ansprüche, die einen Wechselrichter bildet.

10. Vorrichtung nach einem der vorhergehenden Ansprüche, die einen elektrisch leitenden Anschluss (100, 110) enthält, der den elektrischen Leistungsstrom (le) empfängt und konfiguriert ist, um den Schalter (2) mit einem Element außerhalb der Vorrichtung zu verbinden, und wobei mindestens einer der zwei Messpunkte ein Kontaktstift (102, 112) ist, der mit dem elektrisch leitenden Anschluss (100, 110) fest verbunden ist.

11. Vorrichtung nach dem vorhergehenden Anspruch, wobei der elektrisch leitende Anschluss ein Anschluss (100) ist, der konfiguriert ist, mit einem Anschluss einer Versorgungsquelle der elektronischen Vorrichtung verbunden zu sein; oder ein Anschluss (110) ist, der konfiguriert ist, mit einem externen Element verbunden zu sein, das vom elektrischen Leistungsstrom (Ic) gesteuert wird.

## Claims

1. Electronic device (1) for controlling two switches, notably for a motor vehicle, this device comprising the two switches (2) in series:
- said two switches (2) being respectively arranged to move from a closed state to an open state:
• when one of the two switches (2) is in the closed state, an electric power current (Ic) flows through said switch (2);
• when one of the two switches (2) is in the open state, said switch (2) blocks the electric power current from flowing;
• when one of the two switches (2) is in a switching phase, said switch (2) switches from the closed state to the open state, or from the open state to the closed state, and a power current having a frequency (FdI/dt) of the variation in the power current flows through said switch (2);
- for each of the switches, two electric potential measurement points (P) are arranged so that, in the phase of switching from the closed state to the open state, there is an inductance between these two measurement points corresponding to a potential difference between the two points, the device furthermore being arranged to make it possible to control, in the switching phase, the variation in the power current flowing through the switch using this potential difference,
the device being **characterized in that** the inductance of one of the switches is upstream of the two switches and the inductance of the other switch is downstream of the two switches.

2. Device according to the preceding claim, the frequency (FdI/dt) of the variation in the power current being, for the fundamental, between 1 MHz and 100 MHz, notably between 10 MHz and 50 MHz.

3. Device according to Claim 1 or 2, the inductance between the two potential measurement points being greater than 0.5 nH, notably greater than 1 nH, for example 2 nH.

4. Device according to one of the preceding claims, wherein, at frequencies which are smaller than the frequency (FdI/dt) of the variation in the power current, notably frequencies which are 100 times smaller than the frequency (FdI/dt) of the variation in the power current, the potentials at the two measurement points are equal.

5. Device according to one of the preceding claims, wherein, in the switching phase, the potential difference between the two measurement points is used to determine the variation in power current flowing through the switch.

6. Device according to one of the preceding claims, wherein, in the switching phase, the potential difference between the two measurement points is kept constant by controlling the power current flowing through the switch.

7. Device according to one of the preceding claims, wherein the switch is a transistor, notably an IGBT.

8. Device according to one of the preceding claims, wherein the two measurement points are connected to one another by an electrical path formed by an electrical conductor (7), preferably comprising a conductive track or a conductive bar, notably a busbar, or an electrical connection tab.

9. Device according to one of the preceding claims, forming an inverter.

10. Device according to one of the preceding claims, comprising an electrically conductive terminal (100, 110) receiving said electric power current (Ic) and configured to connect said switch (2) to an element which is external to the device, and
wherein at least one of the two measurement points is a pin (102, 112) which is integral with said electrically conductive terminal (100, 110).

11. Device according to the preceding claim, wherein the electrically conductive terminal is a terminal (100) configured to be connected to a terminal of a power source of the electronic device; or is a terminal (110) configured to be connected to an external element controlled by the electric power current (Ic).
